(19) Europäisches Patentamt
European Patent Office
Office européen des brevets

(11) Publication number : 0 546 598 B1

(12) # EUROPEAN PATENT SPECIFICATION

(45) Date of publication of patent specification : **11.01.95 Bulletin 95/02**

(51) Int. Cl.[6] : **G03C 8/28**, G03F 7/07

(21) Application number : **92203584.5**

(22) Date of filing : **20.11.92**

(54) **Image receiving layer for use in a silver salt diffusion transfer process.**

(30) Priority : **09.12.91 EP 91203210**

(43) Date of publication of application : **16.06.93 Bulletin 93/24**

(45) Publication of the grant of the patent : **11.01.95 Bulletin 95/02**

(84) Designated Contracting States : **BE DE FR GB NL**

(56) References cited :
**EP-A- 0 278 766**
**EP-A- 0 449 340**
**FR-A- 2 033 885**
**FR-A- 2 338 516**
**GB-A- 1 358 163**
**US-A- 3 814 696**
**US-A- 4 376 157**
**PATENT ABSTRACTS OF JAPAN vol. 5, no. 81 (P-63)(753) & JP-A-56027151**

(73) Proprietor : **AGFA-GEVAERT naamloze vennootschap**
**Septestraat 27**
**B-2640 Mortsel (BE)**

(72) Inventor : **De Keyzer, René, c/o Agfa-Gevaert N.V., DIE 3800**
**Septestraat 27**
**B-2640 Mortsel (BE)**
Inventor : **Vanmeenen, Yves, c/o Agfa-Gevaert N.V., DIE 3800**
**Septestraat 27**
**B-2640 Mortsel (BE)**
Inventor : **Vaes, Jos, c/o Agfa-Gevaert N.V., DIE 3800**
**Septestraat 27**
**B-2640 Mortsel (BE)**

EP 0 546 598 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

1. Field of the invention.

The present invention relates to a silver salt diffusion transfer material and to a method for obtaining an image or a lithographic printing plate therewith.

2. Background of the invention.

The principle of the silver complex diffusion transfer process (hereinafter referred to as DTR process) is well known from the description in U.S. Pat. NO. 2,352,014 and in the book "Photographic Silver Halide Diffusion Processes" by André Rott and Edith Weyde - The Focal Press - London and New York, (1972).

In the DTR process, the silver complex is imagewise transferred by diffusion from a silver halide emulsion layer to an image receptive layer and transformed therein into a silver image generally in the presence of physical development nuclei. For this purpose, the imagewise exposed silver halide emulsion layer is arranged so as to be in contact with or is brought into contact with the image receptive layer in the presence of a developing agent and a solvent for the silver halide, thereby to convert the unexposed silver halide into a soluble silver complex. In the exposed areas of the silver halide emulsion layer, the silver halide is developed into silver which is insoluble and, hence, cannot diffuse. In the unexposed areas of the silver halide emulsion layer, the silver halide is converted into a soluble silver complex and is transferred to an image receptive layer wherein the silver complex formes a silver image generally in the presence of development nuclei.

The DTR process can be utilized in a wide field such as reproduction of documents, making of printing plates, preparation of block copies, and instant photography.

Particularly in reproducing documents or preparing block copies, an imaging element having a silver halide emulsion layer is brought into close contact with a positive material having an image receptive layer in a DTR processing solution generally containing a silver-complexing agent, thereby to form a silver image in the receptive layer of the positive material. The silver image in these cases is required to be pure black or bluish black in color and sufficiently high in density. It is also important that the silver image be high in contrast and sharpness, excellent in image reproducibility, and preferably high in transfer speed. In addition, these properties of the positive material should not be greatly dependent upon the processing conditions such as, for example. processing time and temperature.

It is easily presumable from the principle of the DTR process that the process of image formation is greatly affected by the processing conditions, especially temperature and speed of processing, and this fact is well known in the art.

As examples of general characteristics of the formed image affected by the environmental processing conditions, particularly processing temperature and conditions of conveyance in DTR process, there may be mentioned the following :

1. Change in sensitivity, general tone, color tone, and density (both reflection and transmission densities).
2. Increased tendency of staining (due to formation of fine grains of silver colloid) on the image receptive sheet.
3. Decreased ability of forming minute images such as fine lines or fine dots with the increase in processing temperature or the decrease in rate of conveyance.

FR-A-2033885 discloses a DTR image receiving material comprising an image receiving layer having noble metal nuclei having an average size of 1.5nm to 6.5nm and wherein at least 80% by number of these nuclei have a size between 2 and 5nm. Such image receiving material is teached to have an increased density and contrast.

US-P-4.376.157 discloses a DTR image receiving material which may comprise noble metals or heavy metal sulphides as the physical development nuclei. The nuclei can be as large as 50nm. In order to obtain a high density image the amount of colloid in the image receiving layer should be such that the thickness thereof is at least 10 times the size of the nuclei.

As mentioned above the DTR-process can also be used for making lithographic printing plates. A DTR-image bearing material can be used as a planographic printing plate wherein the DTR-silver image areas form the water-repellant ink-receptive areas on a water-receptive ink-repellant surface. The DTR-image can be formed in the image-receiving layer of a sheet or web material which is a separate element with respect to the photographic silver halide emulsion material (a so-called two-sheet DTR element) disclosed in e.g. DE-A-2.346.378 or in the image-receiving layer of a so-called single-support-element, also called mono-sheet element, which contains at least one photographic silver halide emulsion layer integral with an image-receiving layer in water permeable relationship therewith. It is the latter mono-sheet version which is preferred for the

preparation of offset printing plates by the DTR method.

To obtain good lithographic properties with such an imaging element it is important that a strong wear resistant silver image is formed in the image receiving layer to obtain a high printing endurance and that the precipitation of silver in the non-printing areas is kept as low as possible to avoid toning of the plate i.e. inkt acceptance in the non-image areas. It is thus also important that the silver image to be used for printing is of high contrast and sharpness.

EP-A-449430 discloses an imaging element having on a support a silver halide emulsion layer and a physical development nuclei layer containing heavy metal sulphides. A good printing plate can be obtained with such a material by using photographic stabilizer in the silver halide emulsion layer.

EP-A-278766 discloses an imaging element comprising on a roughened aluminium support in the order given a layer containing physical development nuclei and a silver halide emulsion layer. The nuclei can be either noble metal nuclei or heavy metal sulphides.

3. Summary of the invention

It is an object of the present invention to provide a DTR-material for obtaining images of high density, high contrast and sharpness and excellent in image reproducibility under a variety of processing temperatures.

It is an object of the present invention to provide a DTR-material for making a lithographic printing plate with excellent lithographic printing properties.

It is an object of the present invention to provide a DTR-process for obtaining an image of high density, high contrast and sharpness and excellent in reproducibility under a variety of processing temperatures.

It is an object of the present invention to provide a DTR-process for making a lithographic printing plate with excellent printing properties.

Further objects of the present invention will become clear from the description hereinafter.

These objects are accomplished by the materials and methods set out in the claims.

4. Detailed description of the invention.

It has been found that when a DTR-process is carried out using an image receiving layer containing physical development nuclei having an average diameter less than 6nm and wherein the number of nuclei having a diameter larger than 4.5nm is less than 15% of the total number of nuclei the quality of the image is improved. More precisely the temperature latitude and maximum density are increased while the density in the non-image areas is decreased so that an image with improved contrast and sharpness is obtained. Furthermore when the DTR-material is used as a lithographic printing plate a printing plate with improved printing endurance and reduced toning is obtained which is partially due to the improved contrast and sharpness of the DTR-image and partially due to the improved hydrophilic character of the non-image areas on the printing plate.

If the fraction of nuclei having a diameter equal to or larger than 4.5nm becomes 15% or more the image quality decreases. The cause of this observation is not clear but it may be assumed that it has something to do with the reactivity of the nuclei which is known to be function of their size i.e. the larger the nuclei the larger their reactivity and vice versa. It thus appears that when the reactivity of the nuclei becomes too large the image quality is reduced. By keeping the number of large nuclei having a diameter larger than 4.5nm below 15% and preferably below 10% the overall reactivity of the nuclei can be controlled so that good image quality and temperature latitude for processing the DTR material is obtained.

Although the size of the nuclei above is expressed by a diameter this does not imply that the nuclei are necessarily spherical. By diameter is meant the diameter of a sphere having an equivalent volume so that the size of nuclei of a variety of shapes can be characterized by the same parameter.

Suitable physical development nuclei for use in accordance with the present invention are sulphides or selenides of heavy metals e.g. PdS, $Ag_2S$, AgNiS. CoS etc.. Preferably used are PdS, $Ag_2S$ or AgNiS nuclei.

The physical development nuclei according to the present invention may be prepared according to known procedures. For example the noble metal nuclei may be prepared as described in US-P-4.304.835. The heavy metal sulphides can be prepared by adding an aqueous solution of heavy metal ions to a solution containing sulphide ions. The obtained nuclei are preferably stabilized using a stabilizer. Suitable stabilizer are large organic molecules that readily absorb to the surface of the nuclei. Examples are heterocyclic compounds containing a water solubilizing group such as -COOH, $-SO_3H$ or $-SO_2H$ e.g. tetrazoles containing a water solubilizing group as described in e.g. the European patent application 218752.

The amount of nuclei used in the image receiving layer is preferably between 0.02 mg/m$^2$ and 10 mg/m$^2$.

According to the present invention the image receiving layer may be contained in a separate image receiving material or may be in water permeable relationship with a light sensitive silver halide emulsion layer

in an imaging element.

According to a first embodiment of the present invention an image is obtained by information-wise exposing an imaging element comprising on a support e.g. a paper support or organic resin support a silver halide emulsion layer and subsequently developing said information-wise exposed imaging element in the presence of developing agent(s) and silver halide solvent(s) whilst in contact with an image receiving material comprising on a support a layer containing physical development nuclei according to the invention.

The support of the image receiving material may be opaque or transparent, e.g. a paper support or resin support. Said support may also be a hydrophilic support e.g. a metal support e.g. aluminium or a support provided with a hydrophilic layer as disclosed in DE-A-2.346.378. In the latter case the obtained silver image may be used in a lithographic printing process.

The image receiving layer comprises for best imaging results the physical development nuclei according to the present invention in the presence of a protective hydrophilic colloid, e.g. gelatin and/or colloidal silica, polyvinyl alcohol etc..

Most of the DTR-positive materials now available on the market are composed of two or even three layers. Such materials normally contain on top of the nuclei containing layer a layer which itself contains no nuclei and otherwise has the same composition as the nuclei containing layer and mainly serves to ensure good contact between the negative and positive material during transfer. Moreover, after drying this layer provides a protective coating for the image receiving layer containing the silver image. It further prevents bronzing or plumming of the black image areas in preventing the protruding of silver from the image receiving layer in the form of a glossy silver mirror (ref. the above mentioned book p. 50).

According to a preferred embodiment the processing liquid and/or the image-receiving element contains at least one image toning agent. In said case the image toning agent(s) may gradually transfer by diffusion from said image-receiving element into the processing liquid and keep therein the concentration of said agents almost steady. In practice such can be realized by using the silver image toning agents in a coverage in the range from 1 $mg/m^2$ to 20 $mg/m^2$ in a hydrophilic waterpermeable colloid layer.

A survey of suitable toning agents is given in the above mentioned book of André Rott and Edith Weyde, p. 61-65, preference being given to 1-phenyl-1H-tetrazole-5-thiol, also called 1-phenyl-5-mercapto-tetrazole, tautomeric structures and derivatives thereof such as 1-(2,3-dimethylphenyl)-5-mercapto-tetrazole, 1-(3,4-dimethylcyclohexyl)-5-mercapto-tetrazole, 1-(4-methylphenyl)-5-mercapto-tetrazole, 1-(3-chloro-4-methylphenyl)-5-mercapto-tetrazole, 1-(3,4-dichlorophenyl)-5-mercapto-tetrazole. Further particularly useful toning agents are of the class of thiohydantoins, preferably a compound corresponding to the following structural formula :

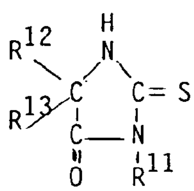

wherein : $R^{11}$ represents an allyl group, and each of $R^{12}$ and $R^{13}$ which may be the same or different represents an alkyl group, e.g. methyl group.

Other particularly useful silver image toning agents are in the class of phenyl substituted mercapto-triazoles, a preferred representative corresponding to the following structural formula :

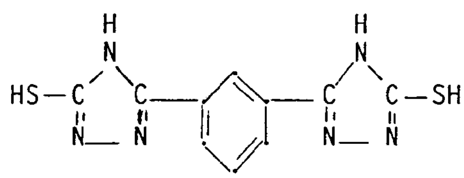

Still further toning agents suitable for use in accordance with the preferred embodiment of the present invention are the toning agents described in the European patent applications 218752, 208346, 218753 and US-P-4683189.

According to a practical embodiment in the image-receiving element the development nuclei containing layer and/or hydrophilic colloid layer in waterpermeable relationship or a back layer at the side of the support opposite to that carrying the image receiving layer contains at least part of the silver image toning agents. Such

procedure results actually in automatic replenishment of toning agent in the processing liquid. The same applies at least partly for the replenishment of the developing agent(s) and silver halide complexing agent(s).

According to another embodiment at least a part of said silver image toning agents is present in the silver halide emulsion material to be developed. Such means that in a practical embodiment at least one of the image toning agents may be used in a hydrophilic waterpermeable colloid layer, e.g. antihalation layer at the side of the support opposite to the side coated with a silver halide emulsion layer or between the support and the silver halide emulsion layer. The coverage of said silver image toning agents in said antihalation layer is preferably in the range of 1 mg/m$^2$ to 20 mg/m$^2$.

The transfer behaviour of the complexed silver largely depends on the thickness of the image-receiving layer and the kind of binding agent or mixture of binding agents used in the nuclei containing layer. In order to obtain a sharp image with high spectral density the reduction of the silver salts diffusing into the image receiving layer must take place rapidly before lateral diffusion becomes substantial. An image-receiving material satisfying said purpose is described in US-4,859,566.

An image-receiving material of this type is very suitable for use with the development nuclei according to the present invention and contains a water-impermeable support coated with (1) an image-receiving layer containing physical development nuclei as referred to hereinbefore dispersed in a waterpermeable binder and (2) a waterpermeable top layer free from development nuclei and containing a hydrophilic colloid, in such a way that :

(i) the total solids coverage of said two layers (1) and (2) is at most 2 g/m$^2$,

(ii) in layer (1) the coverage of the nuclei is in the range of 0.1 mg/m$^2$ to 10 mg/m$^2$, and the coverage of binder is in the range of 0.4 to 1.5 g/m$^2$, and

(iii) in said top layer (2) the coverage of hydrophilic colloid is in the range of 0.1 to 0.9 g/m$^2$.

The coating of said layers proceeds preferably with slide hopper coater or curtain coater known to those skilled in the art.

It has been found that an image receiving material having a composition as described in the above paragraph has an improved stability during storage since it is less susceptible to the build-up of yellow stain during storage.

A white appearance of the image background even when a yellow stain would still appear on storage is obtained by incorporation of optical brightening agents in the support, image-receiving layer and/or interlayer between the support and the image-receiving layer.

According to a particular embodiment the nuclei containing layer (1) is present on a nuclei-free underlying hydrophilic colloid undercoat layer or undercoat layer system having a coverage in the range of 0.1 to 1 g/m$^2$ of hydrophilic colloid, the total solids coverage of layers (1) and (2) together with the undercoat being at most 2 g/m$^2$.

The undercoat optionally incorporates substances that improve the image quality, e.g. incorporates a substance improving the image-tone or the whiteness of the image background. For example, the undercoat may contain a fluorescent substance, silver complexing agent(s) and/or development inhibitor releasing compounds known for improving image sharpness.

According to a special embodiment the image-receiving layer (1) is applied on an undercoat playing the role of a timing layer in association with an acidic layer serving for the neutralization of alkali of the image-receiving layer. By the timing layer the time before neutralization occurs is established, at least in part, by the time it takes for the alkaline processing composition to penetrate through the timing layer. Materials suitable for neutralizing layers and timing layers are disclosed in Research Disclosure July 1974, item 12331 and July 1975, item 13525.

In the image-receiving layer (1) and/or in said top layer (2) and/or in an undercoat gelatin is used preferably as hydrophilic colloid. In layer (1) gelatin is present preferably for at least 60 % by weight and is optionally used in conjunction with an other hydrophilic colloid, e.g. polyvinyl alcohol, cellulose derivatives, preferably carboxymethyl cellulose, dextran, gallactomannans, alginic acid derivatives, e.g. alginic acid sodium salt and/or watersoluble polyacrylamides. Said other hydrophilic colloid may be used also in the top layer for at most 10 % by weight and in the undercoat in an amount lower than the gelatin content.

The image-receiving layer and/or a hydrophilic colloid layer in water-permeable relationship therewith may comprise a silver halide developing agent and/or silver halide solvent, e.g. sodium thiosulphate in an amount of approximately 0,1 g to approximately 4 g per m$^2$.

The image-receiving layer or a hydrophilic colloid layer in water-permeable relationship therewith may comprise colloidal silica.

The image-receiving layer may contain as physical development accelerators, in operative contact with the developing nuclei, thioether compounds such as those described e.g. in DE-A-1,124,354; US-A-4,013,471; US-A-4,072,526; and in EP 26520.

When applying an optical brightening agent in the image-receiving material preference is given to an optical brightening agent that is inherently by its structure resistant to diffusion or is made resistant to diffusion by use in conjunction with another substance wherein it is dissolved or whereto it is adsorbed.

For example, to make an optical brightening agent resistant to diffusion one of the following techniques may be applied.

According to a first technique known from colour photography the optical brightening compound is substituted with a long chain aliphatic residue and ionomeric residue as is known in the synthesis of diffusion resistant colour couplers.

According to a second technique an optical brightening agent of the oleophilic type is incorporated in droplets of a water-immiscible solvent, so-called "oilformer", e.g. dibutylphthalate.

According to a third technique the optical brightening agent is used in conjunction with a polymeric hydrophilic colloid adsorber, a so-called trapping agent, e.g. poly-N-vinylpyrrolidinone as described e.g. in US-P 3,650,752, 3,666,470 and 3,860,427 and published European patent application 0 106 690.

According to a fourth technique latex compositions are used wherein latex particles are loaded, i.e. contain in dissolved and/or adsorbed state an optical brightening agent as described e.g. in German Offenlegungsschrift (DE-OS) 1,597,467 and in US-P 4,388,403.

The image-receiving layer and/or other hydrophilic colloid layer of an image-receiving material used in a DTR-process according to the present invention may have been hardened to some extent to achieve enhanced mechanical strength. Appropriate hardening agents for hardening the natural and/or synthetic hydrophilic colloid binding agents in the image-receiving layer include e.g. formaldehyde, glyoxal, mucochloric acid, and chrome alum. Other suitable hardening agents for hardening the hydrophilic colloid binding agents in the image-receiving layer are vinylsulphonyl hardeners, e.g. as described in Research Disclosure 22,507 of Jan. 1983.

According to a preferred embodiment hardening is effected by incorporating a hardener precursor in the image-receiving layer, the hardening of the hydrophilic colloid therein being triggered by the treatment with an alkaline processing liquid during processing.

In the process of the present invention the image-receiving material can be used in the form of roll film or sheet film or in the form of a filmpack e.g., for in-camera-processing.

The image-receiving material can be used in conjunction with any type of photographic silver halide emulsion material suited for use in diffusion transfer reversal processing. The silver halide emulsion material may contain one or more hydrophilic colloid - silver halide emulsion layers.

In the photographic material to be processed after exposure with a alkaline processing solution in combination with a DTR-image-receiving material according to the present invention, the hydrophilic colloid silver halide emulsion layer can be coated from any photosensitive silver halide emulsion comprising a hydrophilic colloid binder, which usually is gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc. The weight ratio of hydrophilic colloid binder to silver halide expressed as equivalent amount of silver nitrate to binder is e.g. in the range of 1:1 to 10:1. The total amount of binder contained on the photosensitive side of the imaging element is preferably between 4g/m$^2$ and 9g/m$^2$, most preferably between 6 and 8g/m$^2$ while the amount of liquid taken up by the imaging element when soaked for 1 min. in a 0.1N aqueous solution of NaOH is preferably between 3.5ml for 1g binder and 7ml for 1g binder.

The photosensitive silver halide used in the present invention may comprise silver chloride, silver bromide, silver bromoiodide, silver chlorobromoiodide and the like, or mixtures thereof. To obtain a sufficiently high rate of solution of the silver halide and a satisfactory gradation necessary for graphic purposes a silver halide emulsion mainly comprising silver chloride is used preferably. This silver chloride emulsion may comprise silver bromide upto 40mole% preferably upto 20 mole% and/or silver iodide upto 2% preferably upto 0.5%. The silver iodide is preferably contained on the surface of the silver halide grains.

The silver halide emulsions may be coarse or fine grain and can be prepared by any of the well known procedures e.g. single jet emulsions, double jet emulsions such as Lippmann emulsions, ammoniacal emulsions, thiocyanate- or thioether-ripened emulsions such as those described in US-A 2,222,264, 3,320,069, and 3,271,157. Surface image emulsions may be used or internal image emulsions may be used such as those described in US-A 2,592,250, 3,206,313, and 3,447,927. If desired, mixtures of surface and internal image emulsions may be used as described in US-A 2,996,382.

The silver halide particles of the photographic emulsions may have a regular crystalline form such as cubic or octahedral form or they may have a transition form. Regular-grain emulsions are described e.g. in J. Photogr. Sci., Vol. 12, No. 5, Sept./Oct. 1964, pp. 242-251. The silver halide grains may also have an almost spherical form or they may have a tabular form (so-called T-grains), or may have composite crystal forms comprising a

mixture of regular and irregular crystalline forms. The silver halide grains may have a multilayered structure having a core and shell of different halide composition. Besides having a differently composed core and shell the silver halide grains may comprise also different halide compositions and metal dopants inbetween.

Two or more types of silver halide emulsions that have been prepared differently can be mixed for forming a photographic emulsion in a photographic material for use with an image receiving material according to the present invention.

The average size expressed as the average diameter of an equivalent sphere of the silver halide grains may range from 0.2 to 1.2 um, preferably between 0.2µm and 0.8µm, and most preferably between 0.3µm and 0.6µm. The size distribution can be homodisperse or heterodispere. A homodisperse size distribution is obtained when 95 % of the grains have a size that does not deviate more than 30 % from the average grain size.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-A 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions can also be sensitized with polyalkylene oxide derivatives, e.g. with polyethylene oxide having a molecular weight of 1000 to 20,000, or with condensation products of alkylene oxides and aliphatic alcohols, glycols, cyclic dehydration products of hexitols, alkyl-substituted phenols, aliphatic carboxylic acids, aliphatic amines, aliphatic diamines and amides. The condensation products have a molecular weight of at least 700, preferably of more than 1000. It is also possible to combine these sensitizers with each other as described in BE-A 537,278 and GB-A 727,982.

The spectral photosensitivity of the silver halide can be adjusted by proper spectral sensitization by means of the usual mono- or polymethine dyes such as acidic or basic cyanines, hemicyanines, oxonols, hemioxonols, styryl dyes or others, also tri- or polynuclear methine dyes e.g. rhodacyanines or neocyanines. Such spectral sensitizers have been described by e.g. F.M. HAMER in "The Cyanine Dyes and Related Compounds" (1964) Interscience Publishers, John Wiley & Sons, New York.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole.

The silver halide emulsions may further contain either or not in combination with one or more developing agents pH controlling ingredients, and other ingredients such as antifogging agents, development accelerators, wetting agents, and hardening agents for gelatin.

The silver halide emulsion layer may comprise light-screening dyes that absorb scattering light and thus promote the image sharpness and, as a consequence thereof, the sharpness of the final printed copy. Light-absorbing dyes that can be used as light-screening dyes have been described in i.a. US-A 4,092,168, US-A 4,311,787 and DE-A 2,453,217. More details about the composition, preparation and coating of silver halide emulsions can be found in e.g. Product Licensing Index, Vol. 92, December 1971, publication 9232, p. 107-109.

As an interesting variant in the DTR-process the silver halide emulsion may consist of a first light-sensitive silver halide emulsion in which a normal latent image is formed upon image-wise exposure and a second silver halide emulsion whose speed is so low that no or almost no latent image is formed therein. When the low-speed silver halide emulsion and the light-sensitive silver halide emulsion are coated to form different layers, the resulting emulsion layers are arranged in DTR-processing in such a way that the low-speed emulsion is remotest from the image-receiving layer. It is also possible to coat one single layer comprising a mixture of both types of emulsion.

Thanks to the combination of light-sensitive and low-speed emulsions a silver image having an enhanced contrast can be obtained. Such may be explained by the fact that upon application of an aqueous alkaline solution to the image-wise exposed light-sensitive silver halide emulsion layer system in the presence of a developing agent and a silver halide solvent a silver image is formed in the image-receiving layer from the additionally obtained silver complexes in the low-speed emulsion layer. No image-background staining in the DTR-print takes place because the reduced silver of the light-sensitive emulsion forms a barrier for silver halide or complexes of the low-speed emulsion that would also tend to migrate towards the image-receiving element.

As a result, the silver halide or complexes thereof diffusing from both the light-sensitive emulsion and the low-speed emulsion together build up said strenghtened high-contrast silver image in the image receiving layer.

As the sensitivity of the low speed emulsion must be low enough to be inert in the photo-exposure, no second ripening or after-ripening thereof is applied.

The low-speed emulsion may be a pure silver chloride emulsion or an emulsion of mixed silver halides comprising silver chloride e.g. a silver chlorobromide or chlorobromoiodide emulsion. However, the low-speed emulsion is preferably a silver chloride emulsion for the greater part. Preferably a fine-grain silver chloride having a particle size in the range of 50 to 500 nm is used.

In case a mixture of low-speed emulsion and of imaging emulsion is coated to form one single layer, the amount of low-speed emulsion may vary within wide limits. Favourable results can be obtained when the ratio of low-speed silver chloride-containing emulsion to image-forming emulsion, expressed in parts by weight of silver nitrate, ranges from 10:1 to 1:1. The amount of low-speed emulsion to be added depends i.a. on its own nature, on the type of image-forming emulsion used, and on the effect desired. It can be determined easily by routineers in the art by making a few comparative tests.

Apart from negative-working silver halide emulsions that are preferred for their high light-sensitivity, use can be made also of direct-positive silver halide emulsions that produce a positive silver image.

For instance, direct-positive emulsions of the type described in US-A 3,062,651 may be employed. In direct-positive emulsions a non-hardening fogging agent such as stannous chloride and formamidine sulphinic acid can be used.

The silver halide emulsion coated side of the photographic material can be provided with a top layer that contains hydrophilic colloids that form a waterpermeable layer. Such top layer is usually free of gelatin. Its nature is such that it does not inhibit or restrain the diffusion transfer of the complexed silver but acts e.g. as an anti-stress layer. Appropriate hydrophilic binding agents for such top layer are e.g. methyl cellulose, the sodium salt of carboxymethyl cellulose, hydroxyethyl cellulose, hydroxyethyl starch, hydroxypropyl starch, sodium alginate, gum tragacanth, starch, polyvinyl alcohol, polyacrylic acid, polyacrylamide, poly-N-vinyl pyrrolidinone, polyoxyethylene, and copoly(methylvinylether/maleic acid). The thickness of this layer depends on the nature of the colloid used and the required mechanical strength. Such layer if present may be transferred at least partially to the image-receiving layer without deleterious action on the image formation.

The imaging element of the present embodiment may contain other additional layers in water permeable relationship with the silver halide emulsion layer. It is especially advantageous to include a base-layer between the support and the photosensitive silver halide emulsion layer. In a preferred embodiment of the present invention said base-layer serves as an antihalation layer so that the reflectance of the support containing said anithalation layer is not more than 25% and preferably not more than 15%. This layer can therefore contain the same light-absorbing dyes as described above for the emulsion layer ; as alternative finely divided carbon black can be used for the same antihalation purposes as described in US-P 2,327,828. Alternatively the support it self may be selected such that it can serve as antihalation means as described in e.g. US 4.165.237. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

Processing of the information-wise exposed imaging element whilst in contact with the receiving material is accomplished using an alkaline processing liquid having a pH preferably between 9 and 13. The pH of the alkaline processing liquid may be established using various alkaline substances. Suitable alkaline substances are inorganic alkali e.g. sodium hydroxide, potassium carbonate or alkanolamines or mixtures thereof. Preferably used alkanolamines are tertiary alkanolamines e.g. those described in EP-A-397925, EP-A-397926, EP-A-397927, EP-A-398435 and US-P-4.632.896. A combination of alkanolamines having both a $pk_a$ above or below 9 or a combination of alkanolamines whereof at least one has a $pk_a$ above 9 and another having a $pk_a$ of 9 or less may also be used as disclosed in the Japanese patent applications laid open to the public numbers 73949/61, 73953/61, 169841/61, 212670/60, 73950/61, 73952/61, 102644/61, 226647/63, 229453/63, US-P-4,362,811, US-P-4,568,634 etc.. The concentration of these alkanolamines is preferably from 0.1 mol/l to 0.9 mol/l.

Suitable developing agents for the exposed silver halide are e.g. hydroquinone-type and 1-phenyl-3-pyrazolidone-type developing agents as well as p-monomethylaminophenol and derivatives thereof. Preferably used is a combination of a hydroquinone-type and 1-phenyl-3-pyrazolidone-type developing agent wherein the latter is preferably incorporated in one of the layers comprised on the support of the photographic material. A preferred class of 1-phenyl-3-pyrazolidone-type developing agents is disclosed in EP-A-449340. Other type

of developing agents suitable for use in accordance with the present invention are reductones e.g. ascorbic acid derivatives. Such type of developing agents are disclosed in EP-A-498968.

The developing agent or a mixture of developing agents can be present in an alkaline processing solution, in the photographic material or the image receiving material. In case the developing agent or a mixture of developing agents is contained in the photographic material and/or image receiving material, the processing solution can be merely an aqueous alkaline solution that initiates and activates the development.

According to the present invention the imaging element is developed in the presence of a silver halide solvent. Preferably used silver halide solvents are water soluble thiosulphate compounds such as ammonium and sodium thiosulphate, or ammonium and alkali metal thiocyanates. Other useful silver halide solvents (or "complexing agents") are described in the book "The Theory of the Photographic Process" edited by T.H. James, 4th edition, p. 474-475 (1977), in particular sulphites and uracil. Further interesting silver halide complexing agents are cyclic imides, preferably combined with alkanolamines, as described in US 4.297,430 and US 4,355,090. 2-mercaptobenzoic acid derivatives are described as silver halide solvents in US 4,297,429, preferably combined with alkanolamines or with cyclic imides and alkanolamines. Dialkylmethylenedisulfones can also be used as silver halide solvent.

The silver halide solvent is preferably present in the processing solution but may also be present in one or more layers comprised on the support of the imaging element and/or receiving material. When the silver halide solvent is incorporated in the photographic material it may be incorporated as a silver halide solvent precursor as disclosed in e.g. Japanese published unexamined patent applications no. 15247/59 and 271345/63, US-P-4,693,955 and US-P-3,685,991.

The processing solution for use in accordance with the present invention may comprise other additives such as e.g. thickeners, preservatives, detergents e.g. acetylenic detergents such as surfynol 104. surfynol 465, surfynol 440 etc. all available from Air Reduction Chemical Company New York. (surfynol is a registered trade mark)

The DTR-process is normally carried out at a temperature in the range of 10°C to 35°C.

The present invention also provides an imaging element for obtaining a lithographic printing plate according to the DTR-process. Thus an imaging element is provided comprising on a support a silver halide emulsion layer and an image receiving layer containing physical development nuclei according to the invention. Suitable silver halide emulsions for use in accordance with this embodiment are those described above. To obtain good printing properties it is preferred that the image receiving layer is free of binder or contains hydrophilic binder in an amount not more than 30% by weight. When the amount of binder is larger than 30% the physical development nuclei will be imbedded in the binder matrix so that no or little silver is formed on the surface of the image receiving layer. As a consequence the silver image areas will not accept ink.

In connection with this embodiment two layer arrangements can be used for obtaining an imaging element suitable for making a lithographic printing plate according to the DTR-process. According to a first arrangement a support e.g. paper or an organic resin support is provided in the order given with a silver halide emulsion layer and the image receiving layer of the present invention. The imaging element preferably also contains a base layer between the support and the silver halide emulsion layer serving as an anti-halation layer such as the anti-halation layer described above. After information-wise exposure and development according to the DTR-process using a processing liquid as described above a silver image is obtained in the image receiving layer. After this development step the imaging element is preferably guided through a neutralization liquid to reduce the alkaline pH of the surface of the developed imaging element. The neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in EP 0,150,517. Finally the neutralization solution can contain wetting agents, preferably compouds containing perfluorinated alkyl groups.

According to the second arrangement an imaging element comprises on a hydrophilic support e.g. anodized aluminium in the order given an image receiving layer containing physical development nuclei according to the present invention and a silver halide emulsion layer. After information-wise exposure and development according to the DTR-process the imaged element is rinsed with water to remove the silver halide emulsion layer and any other optional layers so that the silver image formed in the image receiving layer is exposed. To facilate the removal of the silver halide emulsion layer(s) an intermediate layer comprising a hydrophilic nonproteinic film forming polymer e.g. polyvinyl alcohol as disclosed in EP-A 410,500 or water swellable polymer beads e.g. polymethyl methacrylate beads as disclosed in EP-A 483415 or mixtures thereof may be included between the nuclei containing layer and silver halide emulsion layer. This intermediate layer may also include anti-halation substances so that said layer may also serve as an anti-halation layer during exposure of the imaging element.

According to the present embodiment for obtaining a lithographic printing plate the silver halide emulsion

contained in the DTR element may be orthochromatically sensitized with a conventional cyanine or merocyanine dye so that said DTR element can be exposed on a process camera using an ordinary light source, e.g. tungsten light.

According to the present embodiment the imaging element can also be used as recording materials for phototype-setting and image-setting devices which employ laser beams as their output energy source.

DTR imaging elements suited for exposure by helium-neon laser (HeNe) or light emitting diode (LED), both devices emitting in the red region of the visual spectrum, according to the present invention may be prepared using an appropriate sensitized silver halide emulsion as disclosed in e.g. US-P 4,501,811 and Japanese Unexamined Patent Publication (Kokai) Nos. 71055/84 and 75838/85.

On the other hand semiconductor lasers, also called laserdiodes, show some advantages compared to other laser types such as low cost price, small size and long life time. Generally the emission wavelength of these semiconductor laser beams is longer than 700 nm and mostly longer than 750 nm. A commercial imagesetter using infra-red laserdiode source was announced by XENOTRON Co in "Ifra Newspaper Techniques" No 7 (oct. 1985) p. 27. These type of lasers can be used in accordance with the present invention by sensisitizing the silver halide emulsion to wavelengths above 700nm using spectral sensitizers as disclosed in e.g. EP 423 399 and US-P-4.784.933.

Although the silver image obtained according to the DTR-process using one of the above two imaging elements is hydrophobic the hydrophobic character of the silver image is preferably enhanced using so called hydrophobizing agents e.g. those described in US-P 3,776,728, and US-P 4,563,410. Preferred compounds are 5-n-heptyl-2-mercapto-1,3,4,-oxadiazol and 3-mercapto-4-acetamido-5-n.heptyl-1,2,4-triazole. These agents may be present in the alkaline processing liquid, in an other liquid used during processing of the imaging element e.g. the neutralization liquid mentioned above or they may be applied after processing using a separate so called finishing solution.

The present invention will now be illustrated by the following examples without however limiting it thereto. All parts are by weight unless otherwise specified.

EXAMPLE 1

A comparative coating solution (no. 1) containing AgNiS physical development nuclei was prepared as follows.

| | | |
|---|---|---|
| Solution A (50°C): | $Ni(NO_3)_2.6H_2O$ | 7g |
| | $AgNO_3$ | 1g |
| | water | 1l |
| Solution B (50°C): | $Na_2S.9H_2O$ | 6.3g |
| | gelatin | 40g |
| | water | 1l |
| Solution C (50°C): | gelatin | 100g |
| | water | 500ml |

Solution A and B were simultaneously added to solution C at a rate of 100ml/min. whilst stirring solution C at 44 rad/s (400rpm). After the addition of A and B to C the obtained mixtured was stirred for an additional 5 minutes. The size of the obtained nuclei and their distribution was measured using Transmission Electron Microscopy. In figure 1 the cumulative number of nuclei represented as a percentage of the total number of nuclei is plotted against the diameter of the nuclei in nanometers. The cumulative distribution curve corresponding to the above sample is the curve corresponding to the squares. From this figure it can be seen that about 16% of the nuclei have a diameter more than 4.5nm while the average diameter is 3.5nm.

Two coating solutions according to the invention were prepared similar to the above procedure with the exception however that a stabilizer was added to solution C in an amount of 15 mmol/l. Table 1 shows the stabilizers added as well as the relative number of nuclei having a diameter of more than 4.5nm.

| Coat. sol. | Stabilizer | % nuclei > 4.5nm | Average diam. (nm) |
|---|---|---|---|
| 2* | 1-(3-(2-sulphobenzamido)-phenyl)-5-mercapto-tetrazole sodium salt | 5 | 2.7 |
| 3 | 5-sulpho-2-mercapto-1,3-benzthiazole sodium salt | 10 | - |

(*) for the cumulative distribution curve see figure 1 the curve corresponding to the crosses.

The above 3 coating solutions containing AgNiS physical development nuclei were used to prepare 9 different image receiving materials as follows.
3 image receiving materials were obtained by providing each of the above coating solutions shortly after their preparation to one side of a paper support having a weight of 110 g/$m^2$ and being coated at both sides with a polyethylene layer to a dry coverage of 2 g/$m^2$. A top layer was then provided of 0.7 g of gelatin per $m^2$.
Additional image receiving materials were prepared in a similar way with the exception that the coating solutions containing physical development nuclei were stored for some time (see table 2) before they were applied to the paper support.
The different characteristics of the thus obtained receiving materials are listed in table 2.

Table 2

| Receiving material no. | Coating solution | Storage before coating |
|---|---|---|
| 1 | 1 | no |
| 2 | 2 | no |
| 3 | 3 | no |
| 4 | 1 | 45 days |
| 5 | 2 | 45 days |
| 6 | 3 | 45 days |
| 7 | 1 | 3 months |
| 8 | 2 | 3 months |
| 9 | 3 | 3 months |

Preparation of a negative working light sensitive material.

A paper support having a weigth of 110g/$m^2$ being coated at both sides with a polyethylene layer was coated at one side with an antihalation layer on the basis of carbon black dispersed in gelatin wherein also hydroquinone and 1-phenyl-4-methyl-pyrazolidin-3-on were present in a coverage of 0.57 g/$m^2$ and 0.32 g/$m^2$. On said antihalation layer an orthochromatically sensitized negative working gelatino silver halide emulsion layer containing an amount of silver chlorobromide (1.8 mol % bromide) equivalent to 2.0 g/$m^2$ of silver nitrate was coated. The average grain size of the silver chlorobromide was 0.3 µm (0.3 microns). The silver halide emulsion layer was overcoated with a thin protective gelatin layer.

Preparation of direct-positive working light sensitive material

The direct-positive working silver halide emulsion material was prepared analogously to Material C of the Example of US-P 4,144,064.

The following processing solutions were prepared.

| Ingredient | P1 | P2 |
|---|---|---|
| I (g) | 1.0 | 1.5 |
| II (g) | 2.0 | 2.0 |
| III (g) | 45.0 | 45.0 |
| IV (g) | 14.0 | 14.0 |
| V (g) | 0.5 | 0.5 |
| VI (g) | 0.0 | 13.0 |
| VII (g) | 0.0 | 4.7 |
| VIII (g) | 0.1 | 0.080 |
| IX (g) | 0.02 | 0.035 |
| MMEA (ml) | 45.0 | 20.0 |
| MDEA (ml) | 30.0 | 45.0 |
| NaOH (g) | 0.0 | 2.0 |
| Water up to | 1 l | 1 l |

I : Hydroxyethylcellulose
II : Ethylenediaminetetraacetic acid tetrasodium salt
III : $Na_2SO_3$ (anhydrous)
IV : $Na_2S_2O_3$ (anhydrous)
V : KBr
VI : Hydroquinone
VII : 1-Phenyl-4-methyl-3-pyrazolidinone
VIII: 1-Phenyl-5-mercapto-tetrazole
IX : 1-(3,4-Dichlorophenyl)-1H-tetrazole-5-thiol

MMEA is N-methyl-ethanolamine.
MDEA is N-methyl-diethanolamine.

Exposure procedure

The photographic materials were exposed through a sensitometric wedge in a contact exposure apparatus operating with a light source having a colour temperature of 3200 °K.

DTR-transfer procedure

The exposed photographic materials were pre-moistened with the above defined processing liquids, the contact time with said liquid being 6 seconds before being pressed together with an image-receiving material as defined above. The transfer processor employed was a COPYPROOF (registered trade name of AGFA-GEVAERT N.V.) type CP 380. The transfer contact time was 30 seconds. The processing was carried out at different processing liquid temperatures being 16, 22 and 32 °C respectively.

The obtained test wedge prints in the image-receiving materials were evaluated with regard to maximum density ($D_{max}$) and gradation (gamma-value), the results of which are listed in the following tables 3 and 4 corresponding to DTR-processes carried out using respectively the negative and positive working light sensitive material. The negative material was processed with processing solution P1 and the positive working light sensitive material using processing solution P2.

Evaluation

All wedge prints were measured on a densitometer MACBETH (registered trade name) type IR 924 behind visual filter, having following wavelength (nm)/optical density (D) characteristics : 700 nm / D = 0; 600 nm / D = 0.2; 500 nm / D = 1.25; 420 nm / D = 3.0.
For the DTR-prints obtained on the paper base image-receiving materials maximum reflection density was measured ($D_{max}$), and the gamma value (maximum gradient of the straigth line portion of the sensitometric curve). The reflection density measurement proceeded according to American National Standard for Photography (Sensitometry) ANSI PH2.17-1985.

Table 3

| Rec. mat. | T=16°C | | T=22°C | | T=32°C | |
|---|---|---|---|---|---|---|
| | $D_{max}$ | Gamma | $D_{max}$ | Gamma | $D_{max}$ | Gamma |
| 1 | 1.91 | 33 | 1.95 | 35 | 1.62 | 45 |
| 2 | 1.86 | 29 | 1.86 | 36 | 1.79 | 54 |
| 3 | 1.92 | 33 | 1.93 | 37 | 1.86 | 52 |
| 4 | 1.86 | 35 | 1.80 | 43 | 1.54 | 38 |
| 5 | 1.74 | 36 | 1.73 | 42 | 1.71 | 56 |
| 6 | 1.83 | 36 | 1.81 | 39 | 1.80 | 58 |
| 7 | 1.94 | 38 | 1.86 | 39 | 1.42 | 29 |
| 8 | 1.86 | 35 | 1.81 | 38 | 1.73 | 53 |
| 9 | 1.98 | 36 | 1.89 | 31 | 1.79 | 54 |

Table 4

| Rec. mat. | T=16°C | | T=22°C | | T=32°C | |
|---|---|---|---|---|---|---|
| | $D_{max}$ | Gamma | $D_{max}$ | Gamma | $D_{max}$ | Gamma |
| 1 | 2.06 | -28 | 2.02 | -36 | 1.76 | -33 |
| 2 | 2.07 | -31 | 1.91 | -40 | 1.90 | -47 |
| 3 | 2.11 | -32 | 1.98 | -34 | 1.90 | -47 |
| 4 | 2.07 | -38 | 2.01 | -48 | 1.61 | -24 |
| 5 | 2.02 | -43 | 1.98 | -56 | 1.84 | -56 |
| 6 | 2.14 | -38 | 2.05 | -50 | 1.94 | -54 |
| 7 | 2.08 | -40 | 1.96 | -59 | 1.56 | -20 |
| 8 | 2.03 | -36 | 2.03 | -60 | 1.82 | -56 |
| 9 | 2.11 | -41 | 2.13 | -60 | 1.91 | -61 |

From the above tables it can be seen that the samples according to the present invention have an improved image-quality especially the maximum density and gradation are increased for the samples according to the invention.

EXAMPLE 2

A comparative coating solution containing PdS nuclei was prepared as follows.

| | | |
|---|---|---|
| Solution A (20°C): | $(NH_4)_2PdCl_4$ | 1.74g |
| | polyvinyl alcohol (1% solution in water) | 20ml |
| | water | 380ml |
| Solution B (20°C): | $Na_2S.9H_2O$ | 1.61g |
| | polyvinyl alcohol (1% solution in water) | 20ml |
| | water | 380ml |
| Solution C (20°C): | polyvinyl alcohol (1% solution in water) | 40ml |
| | water | 760ml |

Solution A and B were simultaneously added to solution C at a rate of 100ml/min. whilst stirring solution C at 0.44 rad/s (400rpm). To remove the excess sulphide the obtained mixture was dialysed using a hollow fiber dialyser having a surface of 1.5m$^2$ and a molecular cut-off of 8000. The solution containing the PdS-nuclei was pumped through the dialyser with a delivery of 400ml/min. and water flows around the fibers with a delivery of 400ml/min. The solution was brought to a conductivety of 0.5mS and the pH was kept between 7.2 and 7.8.

The size of the obtained nuclei and their distribution was measured using Transmission Electron Microscopy and is represented as a cumulative distribution in figure 2. In figure 2 the cumulative number of nuclei represented as a percentage of the total number of nuclei is plotted against the diameter of the nuclei in nanometers. The cumulative distribution curve corresponding to the above sample is the curve corresponding to the squares. From this figure it can be seen that about 23% of the nuclei have a diameter larger than 4.5nm while the average diameter is 3.9nm.

A coating solution containing PdS-nuclei according to the invention was prepared similar to the above procedure with the exception that 3.23g of $Na_2S.9H_2O$ was added to solution C. The cumulative distribution of the nuclei is shown in figure 2 by the curve corresponding to the crosses. From this figure it can be seen that about only 2% of the nuclei have a diameter more than 4.5nm while the average diameter is 1.8nm.

A comparative receiving element and a receiving element were prepared according to the procedure described in example 1 using respectively the comparative coating solution and the coating solution of the invention. The DTR-process was carried out using an image-wise exposed negative or positive working light sensitive material as described in example 1. The DTR-process was performed at 16°C, 22°C and 32°C. The results obtained with a negative and positive working light sensitive material are shown in respectively table 5 and 6. The negative material was processed with processing solution P1 and the positive working light sensitive material using processing solution P2. Evaluation was made similar as in example 1 with the addition that the density in the non-image areas was also measured.

Table 5

| Rec. mat. | T=16°C | | | T=22°C | | | T=32°C | | |
|---|---|---|---|---|---|---|---|---|---|
| | $D_{max}$ | $D_{min}$ | Gamma | $D_{max}$ | $D_{min}$ | Gamma | $D_{max}$ | $D_{min}$ | Gamma |
| comparitive | 1.71 | 0.104 | 24 | 1.66 | 0.104 | 30 | 1.69 | 0.103 | 41 |
| invention | 1.72 | 0.105 | 28 | 1.70 | 0.103 | 39 | 1.71 | 0.103 | 54 |

Table 6

| Rec. mat. | T=16°C | | | T=22°C | | | T=32°C | | |
|---|---|---|---|---|---|---|---|---|---|
| | $D_{max}$ | $D_{min}$ | Gamma | $D_{max}$ | $D_{min}$ | Gamma | $D_{max}$ | $D_{min}$ | Gamma |
| comparitive | 2.04 | 0.104 | -29 | 1.92 | 0.102 | -48 | 1.89 | 0.102 | -52 |
| invention | 1.97 | 0.104 | -37 | 1.93 | 0.101 | -55 | 1.96 | 0.103 | -58 |

From the above tables it can be seen that the gradation is increased a all processing temperature for the invention sample with respect to the comparitive sample. Furthermore the maximum density remains constant over the temperature range tested for the invention sample while a decrease is seen for the comparitive sample.

EXAMPLE 3

A gelatino silver halide emulsion was prepared by double jet precipitation by slowly mixing with stirring an aqueous solution of $AgNO_3$ having a concentration of 2 mole/l, and an aqueous solution having a concentration of 1.7 mole/l of NaCl, 0.48 mole/l of KBr and 0.001 mole/l of KI. Before the precipitation $5.10^{-4}$ mole/l of sodium hexachlororhodaat was added to the silver nitrate solution. In a second part of the precipitation an aqueous solution of $AgNO_3$ having a concentration of 1 mole/l was slowly mixed with an aqueous solution of NaCl at a concentration of 1.3 mole/l.

The temperature during the silver halide formation was 55 °C.

The obtained core-shell emulsion was cooled, flocculated and washed. Gelatin was added in an amount sufficient to reach a ratio of 2/3 by weight of gelatin to silver halide, expressed as equivalent amount of silver nitrate.

Subsequently a chemical ripening was carried out in a conventional way known to those skilled in the art using thiosulphate and gold salts.

Finally the emulsion was sensitized for the red spectral region.

A photographic DTR mono-sheet material was prepared as follows. One side of a paper support weighting 135 $g/m^2$ and coated on both sides with polyethylene was subjected to corona discharge and then coated with two layers by a double layer coating technique the layer nearer to the support being the antihalation layer and the other being the emulsion layer. The emulsion was coated at an amount of silver halide corresponding to 1.5 g $AgNO_3$ /$m^2$. This emulsion layer contained 0.1 $g/m^2$ of 1-phenyl-3-pyrazolidinone and 1.0 $g/m^2$ of gelatin.

The antihalation layer contained carbon black, silica particles of 5 micron average size and gelatin at 3 $g/m^2$. The gelatin was lime treated and substantially free of calcium ions (1000 ppm or less).

After drying these layers were subjected to a temperature of 40 °C for 5 days and then overcoated with the comparitive coating solution of example 2 to which hydroquinone and formaldehyde were added so that they are contained in the physical development nuclei layer in an amount of respectively 0.4$g/m^2$ and 100 $mg/m^2$. The content of nuclei in said layer was 0.7$mg/m^2$.

A sample according to the invention was prepared similar with the exception that the coating solution according to the invention described in example 2 was used.

The following processing solutions were prepared :

| <u>Transfer developer</u> | |
|---|---|
| sodium hydroxide (g) | 30 |
| sodium sulphite anh. (g) | 33 |
| potassium thiocyanate (g) | 20 |
| 3-mercapto-4-acetamido-5-n.heptyl-1,2,4-triazole (g) | 0.15 |
| water to make | 1 l |

| <u>Neutralization solution</u> | |
|---|---|
| citric acid | 10 g |
| sodium citrate | 35 g |
| cysteine | 1 g |
| sodium sulphite anh. | 5 g |
| phenol | 50 mg |
| water to make | 1 l |

| Dampening solution | |
|---|---|
| water | 880 ml |
| citric acid | 6g |
| boric acid | 8.4g |
| sodium sulphate anh. | 25g |
| ethyleneglycol | 100g |
| colloidal silica | 28g |

Both imaging elements described above were image-wise exposed in the HeNe laser containing imagesetter CG 9600, marketed by AGFA COMPUGRAPHIC, a division of AGFA CORPORATION, were subsequently treated with the described activator solution for 10 seconds at 30 °C, thereupon treated with the described neutralization solution at 25 °C and finally dried.

Each of the thus obtained printing plates were mounted on an offset printing machine ( AB Dick 9860 CD - trade name for offset printing machine manufactured by AB DICK Co). During the printing run the described dampening solution and magnetic ink (AB-Dick Magnetic ink 3-3101) was used in each case.

The sensitometric properties of the developed imaging elements were characterized by the transmission density, reflection density, gradation measured by the maximum gradient of the sensitometric curve (Gamma(S)) between the points 25% above the minimum density and 25% below the maximum density and gradation measured by the maximum gradient of the sensitometric curve between the points 25% below the maximum density and the maximum density (Gamma(T)).

The lithographic properties were characterized by the printing endurance which was evaluated as the number of printed copies before disappearance of small details on the copy begins to occur and the degree of toning of the plates i.e. ink acceptance in the non-image areas. Table 7 represents the results for each of the 2 printing plates.

Table 7

| Plate | $D_R$ | $D_T$ | Gamma(S) | Gamma(T) | print. endurance | toning |
|---|---|---|---|---|---|---|
| comparitive | 0.54 | 1.26 | 1.62 | 1.40 | 4000 | occurred |
| invention | 0.54 | 1.27 | 1.84 | 1.75 | 4000 | no |

## Claims

1. An image receiving material comprising a receiving layer containing AgNiS physical development nuclei having an average diameter less than 6nm and wherein the number of nuclei having a diameter larger than 4.5nm is less than 15% of the total number of nuclei contained in said receiving layer.

2. An image receiving material according to claim 1 wherein said nuclei having a diameter more than 4.5nm is less than 10%.

3. An imaging element comprising on a support a silver halide emulsion layer and an image receiving layer containing sulphides or selenides of heavy metals as physical development nuclei, said physical development nuclei having an average diameter less than 6nm and wherein the number of nuclei having a diameter larger than 4.5nm is less than 15% of the total number of nuclei contained in said receiving layer and said image receiving layer being free of binder or containing a hydrophilic binder in an amount not more than 30 % by weight.

4. An imaging element according to claim 3 wherein said nuclei having a diameter larger than 4.5nm is less than 10%.

5. An imaging element according to claim 3 or 4 wherein said image receiving layer is the outermost layer.

6. An imaging element according to claim 3 or 4 wherein said support is hydrophilic and said image receiving layer is provided directly on said support.

7. A method for obtaining an image comprising the steps of information-wise exposing an imaging element comprising on a support a silver halide emulsion and developing said information-wise exposed imaging element in the presence of developing agent(s) and silver halide solvent(s) whilst in contact with a non-light sensitive image receiving material as defined in claim 1 or 2.

8. A method for obtaining a lithographic printing plate comprising the steps of information-wise exposing an imaging element as defined in claim 5 and subsequently developing said information-wise exposed imaging element in the presence of developing agent(s) and silver halide solvent(s).

9. A method for obtaining a lithographic printing plate comprising the steps of information-wise exposing an imaging element as defined in claim 6, subsequently developing said information-wise exposed imaging element in the presence of developing agent(s) and silver halide solvent(s) thereby forming a silver image in said image receiving layer and rinsing said developed imaging element with water to expose said silver image formed in said image receiving layer.

## Patentansprüche

1. Ein Bildempfangsmaterial, das eine physikalische Entwicklungskeime aus AgNiS enthaltende Empfangsschicht umfaßt, wobei der durchschnittliche Durchmesser dieser physikalischen Entwicklungskeime kleiner ist als 6 nm und dadurch gekennzeichnet, daß die Zahl der Keime, deren Durchmesser größer ist als 4,5 nm, weniger als 15 % der Gesamtzahl der in der Empfangsschicht enthaltenen Keime ausmacht.

2. Ein Bildempfangsmaterial nach Anspruch 1, dadurch gekennzeichnet, daß die Zahl der Keime, deren Durchmesser größer ist als 4,5 nm, weniger als 10 % beträgt.

3. Ein bilderzeugendes Element, das auf einem Träger eine Silberhalogenidemulsionsschicht und eine Bildempfangsschicht umfaßt, die Schwermetallsulfide oder -selenide als physikalische Entwicklungkeime enthält, deren durchschnittlicher Durchmesser kleiner ist als 6 nm und dadurch gekennzeichnet, daß die Zahl der Keime, deren Durchmesser größer ist als 4,5 nm, weniger als 15 % der Gesamtzahl der in der Empfangsschicht enthaltenen Keime ausmacht und die Bildempfangsschicht bindemittelfrei ist oder ein hydrophiles Bindemittel in einer Menge von nicht mehr als 30 Gew.-% enthält.

4. Ein bilderzeugendes Element nach Anspruch 3, dadurch gekennzeichnet, daß die Zahl der Keime, deren Durchmesser größer ist als 4,5 nm, weniger als 10 % beträgt.

5. Ein bilderzeugendes Element nach Anspruch 3 oder 4, dadurch gekennzeichnet, daß die Bildempfangsschicht die äußerste Schicht ist.

6. Ein bilderzeugendes Element nach Anspruch 3 oder 4, dadurch gekennzeichnet, daß der Träger hydrophil ist und die Bildempfangsschicht geradeswegs auf den Träger aufgetragen wurde.

7. Ein Verfahren zur Erzeugung eines Bilds, das die folgenden Schritte umfaßt : das informationsweise Belichten eines bilderzeugenden Elements, das eine Silberhalogenidemulsion auf einem Träger enthält, und das Entwickeln dieses informationsweise belichteten, bilderzeugenden Elements in der Gegenwart einer oder mehrerer Entwicklersubstanzen und eines oder mehrerer Silberhalogenidlösungsmittel, während es mit einem lichtunempfindlichen Bildempfangsmaterial nach Anspruch 1 oder 2 in Berührung ist.

8. Ein Verfahren zur Erzeugung einer lithografischen Druckplatte, das die folgenden Schritte umfaßt : das informationsweise Belichten eines bilderzeugenden Elements nach Anspruch 5 und das anschließende Entwickeln dieses informationsweise belichteten, bilderzeugenden Elements in der Gegenwart einer oder mehrerer Entwicklersubstanzen und eines oder mehrerer Silberhalogenidlösungsmittel.

9. Ein Verfahren zur Erzeugung einer lithografischen Druckplatte, das die folgenden Schritte umfaßt : das informationsweise Belichten eines bilderzeugenden Elements nach Anspruch 6, das anschließende Entwickeln dieses informationsweise belichteten, bilderzeugenden Elements in der Gegenwart einer oder

mehrerer Entwicklersubstanzen und eines oder mehrerer Silberhalogenidlösungsmittel, infolge dessen in der Bildempfangsschicht ein Silberbild erzeugt wird, und das Spülen dieses entwickelten, bilderzeugenden Elements mit Wasser, um das in der Bildempfangsschicht erzeugte Silberbild bloßzulegen.

## Revendications

1. Un matériau récepteur d'image comprenant une couche réceptrice contenant des germes d'AgNiS de développement physique ayant un diamètre moyen inférieur à 6 nm, caractérisé en ce que le nombre de germes au diamètre supérieur à 4,5 nm constitue moins de 15 % du nombre total des germes contenus dans la couche réceptrice.

2. Un matériau récepteur d'image suivant la revendication 1, caractérisé en ce que le nombre de germes au diamètre supérieur a 4,5 nm est de moins de 10 %.

3. Un élément formateur d'image comprenant sur un support une couche d'émulsion à l'halogénure d'argent et une couche réceptrice d'image contenant des sulfures ou des séléniures de métaux lourds en tant que germes de développement physique, ces germes de développement physique ayant un diamètre moyen inférieur à 6 nm, caractérisé en ce que le nombre de germes au diamètre supérieur à 4,5 nm constitue moins de 15 % du nombre total des germes contenus dans cette couche réceptrice et la couche réceptrice d'image est exempte de liant ou contient un liant hydrophile dans une quantité ne dépassant pas les 30 % en poids.

4. Un élément formateur d'image suivant la revendication 3, caractérisé en ce que le nombre de germes au diamètre supérieur à 4,5 nm est de moins de 10 %.

5. Un élément formateur d'image suivant la revendication 3 ou 4, caractérisé en ce que la couche réceptrice d'image est la couche extérieure.

6. Un élément formateur d'image suivant la revendication 3 ou 4, caractérisé en ce que le support est hydrophile et la couche réceptrice d'image a été directement appliquée sur le support.

7. Un procédé pour la formation d'une image comportant les opérations suivantes : l'exposition suivant une information d'un élément formateur d'image comprenant une émulsion à l'halogénure d'argent sur un support et le développement de cet élément formateur d'image exposé suivant une information en présence d'un ou plusieurs développateurs et d'un ou plusieurs solvants de l'halogénure d'argent pendant qu'il est en contact avec un matériau récepteur d'image, insensible à la lumière, suivant la revendication 1 ou 2.

8. Un procédé pour la confection d'une plaque d'impression lithographique comportant les opérations suivantes : l'exposition suivant une information d'un élément formateur d'image suivant la revendication 5 et le développement consécutif de cet élément formateur d'image exposé suivant une information en présence d'un ou plusieurs développateurs et d'un ou plusieurs solvants de l'halogénure d'argent.

9. Un procédé pour la confection d'une plaque d'impression lithographique comportant les opérations suivantes : l'exposition suivant une information d'un élément formateur d'image suivant la revendication 6, le développement consécutif de cet élément formateur d'image exposé suivant une information en présence d'un ou plusieurs développateurs et d'un ou plusieurs solvants de l'halogénure d'argent, d'où il résulte la formation d'une image argentique dans la couche réceptrice d'image, et le rinçage à l'eau de cet élément formateur d'image développé afin d'exposer l'image argentique formée dans la couche réceptrice d'image.

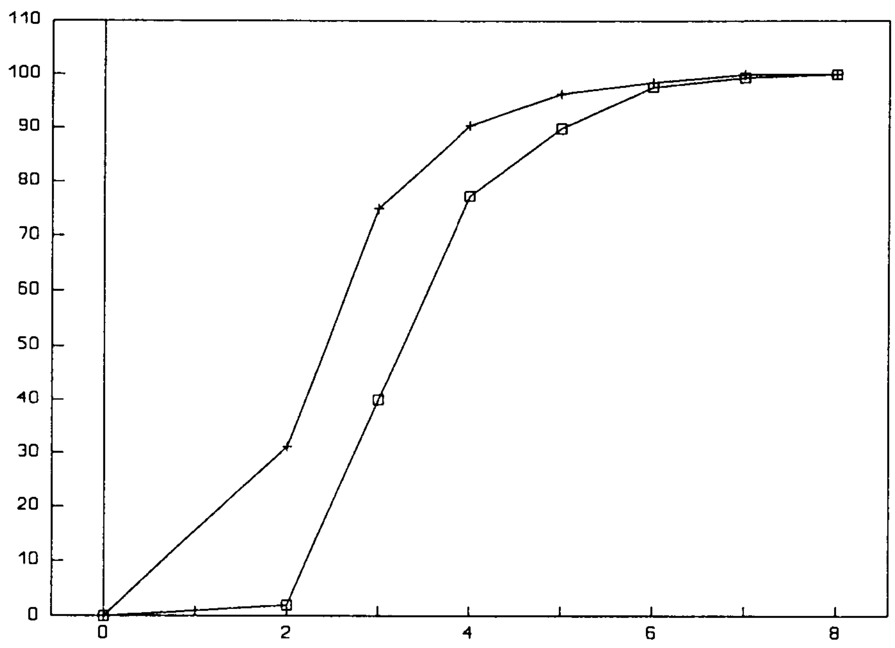


FIGURE 1

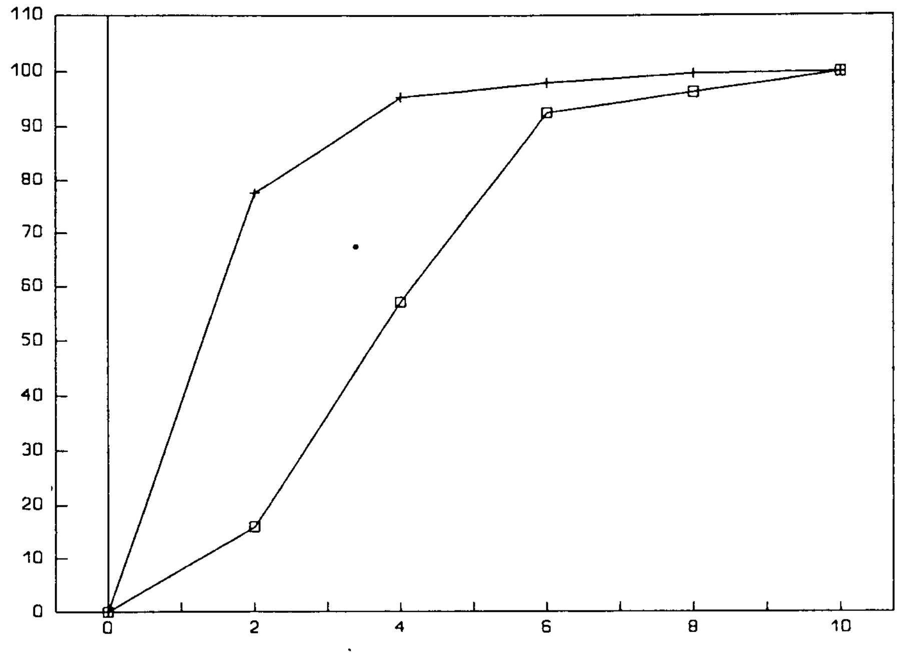


FIGURE 2